# EUROPEAN PATENT SPECIFICATION

(11) **EP 0 402 113 B1**
(45) Date of publication and mention of the grant of the patent: **06.09.1995**
(21) Application number: 90306142.2
(22) Date of filing: 06.06.1990
(51) Int. Cl.: H03L 7/093

(54) **VCO frequency control circuit**
Frequenzsteuerschaltung für VCO
Circuit de commande de fréquence pour VCO

(30) Priority: 07.06.1989 US 363566
(43) Date of publication of application: 12.12.1990
(73) Proprietor: International Business Machines Corporation, Armonk, N.Y. 10504 (US)
(72) Inventor: Chung, Paul Wingshing, San Jose, CA 95119 (US); Gee, Ralph Leonard, San Jose, CA 95148 (US); Lang, Luke Chung Kuang, Santa Clara, CA 95051 (US); Saber, Paik, San Jose, CA 95139 (US)
(74) Representative: Moss, Robert Douglas

(56) References cited:
- EP-A- 0 075 376
- WO-A-85/05744
- DE-A- 2 036 368
- DE-A- 3 126 116
- US-A- 3 710 274
- US-A- 4 633 298
- IBM TECHNICAL DISCLOSURE BULLETIN. vol. 23, no. 1, June 80, NEW YORK US pages81-82; M. L. Carnes et al.: "CYCLE-SYNCHRONIZED PHASE-LOCKED LOOP"

## Description

### Technical Field of the Invention

This invention relates to a circuit suitable for setting and dynamically adjusting the free-running frequency of a voltage controlled oscillator (VCO) in a phase-locked loop (PLL).

### Background of the Invention

Currently all PLLs, except the all-digitally-implemented PLLs, utilise a VCO to provide the clocking means. A VCO is employed, for example, for this purpose in the design of a magnetic recording channel.

A major problem in the design of PLLs is assuring a very tight tolerance for the free-running frequency of the VCO. To achieve this, temperature compensation techniques are often incorporated into the design of the VCO circuitry. However, since the variations in process parameters (such as oxide thickness, threshold voltage, etc.) are statistically independent of each other, the effect on the circuit cannot be fully overcome using design techniques. The VCO free-running frequency can have as much as 30%-50% variation from chip to chip. However, for a PLL to function correctly it is essential that the free-running frequency tolerance be very tight and not vary more than 1%-2%.

To date, the chip-to-chip variation in VCO free-running frequency has been resolved by physically modifying the PLL chip by using (1) a laser trim technique involving trimming resistors or capacitors which are on the module substrate and connected to the VCO circuit inside the chip; or (2) a high current zapping technique to blow out resistors on the chip at the wafer level. Both of these techniques are expensive and time consuming, and the high current zapping technique is unreliable for the tight tolerances required for a VCO.

U.S. Patent 4,380,742 describes a circuit for synchronising the frequency and/or phase of an output frequency signal to a reference frequency signal. This phase-locked or frequency locked circuit comprises an oscillator the components of which must be trimmed, as in other prior art frequency synthesising circuits such as those described in U.S. Patents 4,654,604; 4,672,477; 3,651,422 and 4,543,661.

German patent application DE-A-3126116 describes a control circuit for tuning a radio receiver to various desired transmitter frequencies. A VCO in the control circuit is set by comparing the VCO output frequency with a desired transmitter frequency as defined in a microcomputer. The comparator output is converted into a VCO tuning voltage by means of a successive approximation register and a DAC.

An article entitled "Cycle-synchronised phase-locked loop" in IBM Technical Disclosure Bulletin, vol 23, no 1, June 1980, pp 81-82, shows a PLL including means operable during an initial start-up period to lock the VCO output signal to a multiple of an input signal. Once lock-up has been achieved the PLL operates in a conventional manner.

### Disclosure of the Invention

There is thus a need for a simplified means for controlling the VCO frequency to compensate for different performance characteristics due to process variations and for eliminating the use of costly techniques such as laser trimming and the like.

Accordingly the invention provides a circuit for controlling the frequency of a voltage controlled oscillator (VCO) forming part of an interconnected phase lock loop and frequency lock loop comprising: a digital to analog converter (DAC) in the PLL, the output of the DAC being connected to the input of the VCO; means for setting the DAC such that its output represents substantially the centre of a preselected PLL lock range; the FLL being operable to initially set the free-running frequency of the VCO to a preselected value, the FLL comprising: a first counter for counting output frequency pulses from the; a second counter for counting frequency pulses from a reference clock and providing a strobe pulse on counting to a preselected count value; a register in which the then existing count in the first counter is stored in response to the strobe pulse; a comparator conditioned by the strobe pulse to compare the count stored in the register with a preselected expected count to provide an output when the stored and expected counts differ; and adjustment means responsive to the comparator output signal to provide a signal to the VCO to adjust the free-running frequency to its preselected value; the circuit further comprising means in the PLL responsive to a deviation of the VCO frequency outside a preselected frequency range to apply a signal to said adjustment means in the FLL to adjust the VCO free-running frequency to lie within the frequency range.

Such a circuit permits the VCO frequency to be adjusted dynamically at the system level to compensate for variations in temperature, power supply, drift of components due to aging, or other factors which cause the VCO frequency to deviate from the frequency range defined within the circuit.

It is preferred that the circuit further includes means for maintaining the VCO frequency within the preselected frequency range comprising means responsive to the VCO output signal and a signal input to the PLL, to which the VCO signal is to be locked, to generate a signal indicative of the frequency error of the PLL, control means for summing the PLL frequency error signal and a signal representing the VCO free running frequency and supplying a control signal derived from the resultant sum to the VCO to change the VCO frequency as necessary to maintain it within the lock range. Thus during normal operation of the PLL, the VCO frequency is kept within the correction range permitted by the circuit.

It is a further preference that the circuit should also permit the free-running frequency to be changed dynamically by programming that will adjust the frequency ratio to enable use of several different data frequencies with a single predetermined servo or other reference frequency for data banding.

In another aspect of the invention there is provided a method of controlling the frequency of a voltage controlled oscillator (VCO) forming part of an interconnected phase lock loop (PLL) and frequency lock loop (FLL), including the step of setting, by means of the FLL, the free-running frequency of the VCO to a preselected value, comprising the steps of: setting a digital-analog converter (DAC) in the PLL, the output of the DAC being connected to the input of the VCO, such that its output represents substantially the centre of a preselected PLL lock range; counting output pulses from the VCO; counting pulses from a reference clock; when the number of reference pulses reaches a preselected value, comparing the counted number of VCO output pulses with a preselected expected count corresponding to the preselected free-running frequency value; and incrementing or decrementing the VCO free-running frequency according to whether the number of counted VCO pulses is lower or higher than the expected count; the method comprising the further step of: in response to a deviation of the VCO frequency outside a preselected frequency lock range, applying a signal indicative of the frequency error from means in the PLL for combination, in the FLL, with a signal indicative of the VCO free-running frequency to adjust the VCO free-running frequency to cause it to lie within said frequency lock range.

It is further preferred that the method further includes the step of subsequently maintaining the frequency of the VCO within the preselected frequency range, comprising the steps of: enabling the PLL; generating a phase error signal indicative of the phase and/or frequency difference between the VCO output signal and the incoming signal to the PLL, generating a frequency error signal from the phase error signal, adding the phase error and frequency error signals to generate a signal reflecting the PLL frequency error and summing the PLL frequency error signal and signal indicative of the VCO frequency to produce a voltage to adjust the VCO frequency as necessary to maintain it within the preselected frequency range.

It is a further preference that the step of adjusting the VCO frequency to bring it back within the preselected range comprises dynamically adjusting the VCO frequency by combining the frequency error signal generated from the phase error signal with a signal indicative of the VCO frequency and summing the combination signal and PLL phase error signal to produce a voltage to restore the VCO frequency to within the frequency range.

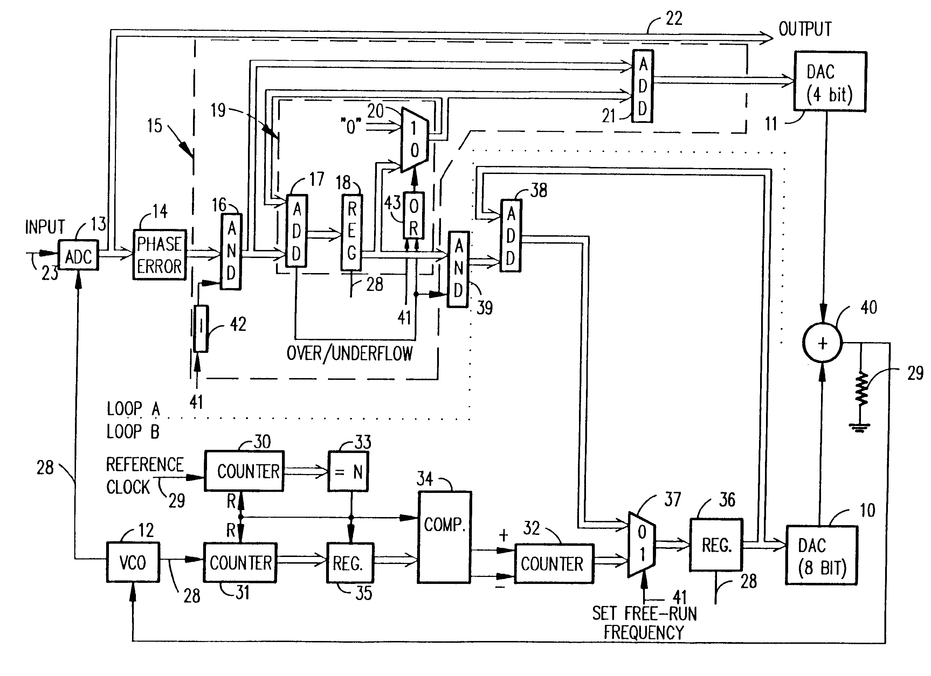

The invention will now be described by way of example only with reference to the accompanying figure which shows a block diagram of a circuit according to one aspect of the present invention.

### Detailed Description of the Invention

A circuit embodying the invention which may be used to set the VCO free-running frequency in a PLL of a magnetic recording channel is shown in the figure and comprises two interconnected loops A, B (shown separated by a dotted line), an eight bit digital to analog converter (DAC) 10, a four bit DAC 11, and a VCO 12. DAC 10 is set to a preselected centre frequency for VCO 12, e.g. 10 MHz; and DAC 11 is set to the centre of a preselected permissable deviation or lock range (e.g., ±10 KHz) from said centre frequency. An analog-to-digital converter (ADC) 13, a phase error generator 14, timing control logic 15, together with the DAC 11 and VCO 12, constitute a PLL. Timing control logic 15 comprises an AND gate 16, an adder 17, a register 18, a multiplexor 20, and an adder 21.

Of these logic components, adder 17, register 18 and multiplexor 20 constitute a digital integrator 19 which converts a digital phase error signal to a digital frequency error signal. The PLL timing control logic 15 controls the four bit DAC 11 to adjust phase differences between the VCO output frequency and the data input frequency to ADC 13, so as normally to maintain the PLL within the preselected lock range. The PLL is operative to lock an output in line 22 to an analog signal supplied via an input line 23 at a desired sample phase. The output signal in 22 is used by the PLL and other parts (not shown) of a utilisation device, such as a magnetic recording channel.

The circuit further comprises a FLL in combination with the PLL. The FLL is used to initially set the free-running frequency of VCO 12 despite variation in components due to process variations; and thereafter it is used to dynamically adjust the free-running frequency to maintain it within the preselected lock range of the PLL in the event of drift due to relatively large changes in supply voltage and/or temperature.

The FLL comprises a line 29 for supplying servo or reference clock pulses from a source (not shown), three counters 30, 31 and 32, two comparators 33 and 34, two registers 35 and 36, a multiplexor 37, an adder 38 connected to an AND gate 39, and a summing node 40, as well as the DAC 10 and VCO 12. Register 36, as well as register 18, is clocked by the VCO 12 output in line 28. Node 40 sums the currents from the DACs 10 and 11 and their sum is converted to an analog bias voltage by resistor 29.

The VCO output frequency is typically a ratio of two integers, N and R, whose values are dependent upon the servo architecture. R is the desired count of counter 31, and N is the maximum count of the reference counter 30.

In operation, at system power up or reset, a "set free-running frequency" signal is brought up in line 41 by programming or firmware for a preselected period of time sufficient to set the free-running frequency for VCO 12. This signal temporarily disables the PLL in the following manner. The signal in 41 is applied through an inverter 42 to AND gate 16, thereby cutting off the output from phase error generator 14 and forcing the output from AND 16 to adder 21 to zero. Meanwhile, the signal in 41 is applied via OR gate 43 to multiplexor 20 to connect the "0" input to adder 21. With both inputs to adder 21 zeroed, DAC 11 is set to zero in two's complement form at substantially the centre of the preselected PLL lock range. Finally, the signal in 41 also conditions multiplexor 37 to connect counter 32 to register 36 for activating the FLL to set the free-running frequency of VCO 12.

The FLL is locked to the reference clock by counters 30, 31. The value of N is controlled by comparator 33. Each time counter 30 counts N reference clock pulses, comparator 33 issues a strobe pulse that resets counters 30, 31 and causes counter 31 to store its count of VCO pulses in register 35.

Comparator 34 is conditioned by the strobe pulse to compare the actual count M of VCO pulses as supplied by counter 31 to register 35 in response to the previous strobe with a preset expected count R for VCO pulses. If M < R, the output of comparator 34 will increment counter 32; whereas if M > R, comparator 34 will decrement counter 32. Multiplexor 37 passes the current value of the VCO frequency from counter 32 to register 36, from which it is fed to DAC 10 and converted to a corresponding analog bias voltage. This voltage is applied via summing circuit 40 at the input to VCO 12 for causing the VCO frequency to be incremented or decremented according to whether M < R or M > R, respectively, until the contents of register 35 equals the value of R.

VCO frequency counter 31 should count to R in the same time that the reference clock frequency counter 30 counts to N. For example, if N=4, R=100 and M=97, the VCO centre frequency is 3 units low. The current value fed to the eight bit DAC 10 should be incremented in increments of 1, as illustrated, to progressively raise the VCO frequency by 3 units until VCO output frequency is exactly R/N times the reference clock frequency; whereupon the VCO free-running frequency is established, and the input to the eight bit DAC 10 will then be held constant. After this, four bit DAC 11 takes over to compensate for phase differences between VCO output frequency and the data input frequency to ADC 13.

In practice, since the DAC 10 preselected free-running frequency and the obtainable VCO frequency will generally not be identical, a tolerance of e.g., R± 2, would be expected. It will be apparent that by increasing the value of R, the tolerance percentage can be reduced. Also, the value of the free-running frequency can be set arbitrarily close to the desired frequency depending upon the value of R and the number of bits in DAC 10.

After the initial setting of the VCO free-running frequency by the FLL, the frequency should normally be maintained within the required frequency range, by the PLL. When the PLL disabling signal on line 41 goes down, the PLL is enabled. Phase error generator 14 thereafter generates a digital phase error signal indicative of the phase and/or frequency difference between the input data and the VCO output signal. The digital integrator 19 generates a digital frequency error signal from the phase error signal. The frequency and phase error signals are summed by adder 21 and the result is supplied to the DAC 11 in the PLL to provide an analog output signal indicative of the PLL frequency error. The outputs from DACs 10 and 11 are summed by summing circuit 40 and the resultant current is converted to a bias voltage by resistor 29 to adjust the VCO frequency as necessary for normally maintaining it within the lock range defined by DAC 11.

If there is no frequency difference between the input signal 23 and the VCO output signal 28, then the PLL would be required to compensate solely for phase difference between the two which would be determined by phase error generator 14. Assuming for the moment that the bottom leg of adder 21 is zero (ie has no influence on the loop) then the phase error would pass through the adder via DAC 11 to VCO 12. This error would act on the VCO in such manner as to correct for this phase error. After several passes round the PLL, the phase error would be driven to zero.

If there is a frequency difference between the input 23 and VCO output 28, then the phase error caused by this frequency difference is added to the total phase error at every clock cycle. To avoid locking onto a signal with a constant phase error caused by the frequency difference, it is necessary to account for it by employing a second order loop. This operates by adding the constant phase error, which is measured by the digital integrator 19, to the measured phase error. If at every clock cycle there is a constant phase error the digital integrator will integrate the value driving the output of the integrator toward the value of the constant phase error. The output of 19 when fed back around the loop reduces the constant phase error. When the magnitude of integrator 19 reaches a value which drives the constant phase error to zero, the integration stops because the phase error is zero.

If, however, the free-running frequency runs out of the PLL normal lock range due, for example, to a significant VCO frequency drift as a result of excessive variations in temperature and/or power supply and/or aging of components then the FLL operates to dynamically restore the VCO free-running frequency setting to within the PLL lock range in the following manner.

Phase error detector 14 generates a digital signal directly proportional to the amount of drift. AND gate 16 will pass the phase error signal to adders 21, 17 because the signal in line 41 is down. When the maximum range of the digital integrator 17, 18, 20 is exceeded in either direction, adder 17 overflows or underflows. The resultant over/underflow signal passes via OR gate 43 to multiplexor 20 which then connects its "0" input to adder 21. Meanwhile the phase error signal from AND 16 is converted to a digital frequency error signal as it passes via adder 17 and register 18 to AND 39. The sign bit which is of the most significant bit (MSB) in register 18 denotes whether there is an overflow or underflow condition. AND 39 is now enabled by the over/underflow signal and passes the contents of register 18 to adder 38. With line 41 down, multiplexor 37 passes the contents of adder 38 via register 36 to DAC 10. The phase error signal from DAC 11 and the signal from DAC 10 (as modified by the frequency error signal) are summed by summing circuit 40, and the resultant current in converted to a bias voltage to increase or decrease the VCO input frequency according to whether the frequency error indicated that the VCO frequency was too low or too high, thereby to adjust the VCO free-running frequency to within the PLL lock range.

Meanwhile, note that the previous VCO free-running frequency is stored in register 36; that adder 38 contains the current VCO frequency; and that this previous frequency is fed back through adder 38 and stored in register 36. Thus, the frequency count in adder 38 is continually kept current with each output from register 36 to DAC 10, as register 36 is clocked by the VCO output in line 28.

It should be noted that the ratio of the VCO frequency to the reference clock frequency can be established or modified by programming. Also different ratios and hence frequencies can be derived by suitable programming from a single servo or other reference frequency. This enables data banding, for example, in Partial Response Maximum Likelihood (PRML) and Peak Detection (PD) type magnetic recording channels.

In summary, the need for laser trimming a VCO to set the VCO free-running frequency is eliminated. This frequency is initially set by the FLL. Thereafter, the PLL is enabled and normally maintains the VCO free-running frequency within the PLL lock range. This frequency is readjusted if and when the PLL exceeds its lock range, as determined by the digital integrator 17, 18, 20. As a result, the VCO free-running frequency is maintained within the PLL lock range.

## Claims

1. A circuit for controlling the frequency of a voltage controlled oscillator (VCO, 12) forming part of an interconnected phase lock loop (PLL) and frequency lock loop (FLL) comprising:
a digital to analog converter (DAC, 11) in the PLL, the output of the DAC being connected to the input of the VCO;
means for setting the DAC such that its output represents substantially the centre of a preselected PLL lock range;
the FLL being operable to initially set the free-running frequency of the VCO to a preselected value, the FLL comprising:
a first counter (31) for counting output frequency pulses from the VCO (12);
a second counter (30) for counting frequency pulses from a reference clock and providing a strobe pulse on counting to a preselected count value;
a register (35) in which the then existing count in the first counter is stored in response to the strobe pulse;
a comparator (34) conditioned by the strobe pulse to compare the count stored in the register with a preselected expected count to provide an output when the stored and expected counts differ; and
adjustment means (32, 37, 36, 10) responsive to the comparator output signal to provide a signal to the VCO to adjust the free-running frequency to its preselected value;
the circuit further comprising means (17, 39, 20) in the PLL responsive to a deviation of the VCO frequency outside a preselected frequency range to apply a signal to said adjustment means in the FLL to adjust the VCO free-running frequency to lie within the frequency range.

2. A circuit as claimed in claim 1, further comprising means for maintaining the VCO frequency within said preselected frequency range comprising:
means responsive to the VCO output signal and a PLL input signal to generate a signal indicative of the PLL frequency error;
control means (40, 29) for summing the PLL frequency error signal and a signal representing the VCO free running frequency and supplying a control signal derived from the resultant sum to the VCO to change the VCO frequency as necessary to maintain it within the lock range.

3. A circuit as claimed in claim 2, wherein the PLL error generating means comprises:
phase error generating means (14) for generating a digital phase error signal derived from the VCO output signal and PLL input signal;
integrating means (19) for deriving a digital frequency error signal from the digital phase error signal;
PLL summing means (21) for summing the phase and frequency error signals;
the PLL DAC (11) being responsive to the resultant sum to provide an analog PLL frequency error signal for supply to adder means (40) in said control means for summation with an analog VCO frequency signal supplied by DAC means (10) in the FLL to produce a bias voltage to adjust the VCO frequency.

4. A circuit as claimed in claim 3 wherein the means responsive to said frequency deviation includes:
means (17) for indicating said deviation;
means (39) responsive to said indication. to supply the frequency error signal generated by the integrating means to DAC means in the FLL; and
means (20) to zero the frequency error signal to the PLL DAC means, wherein the output of the FLL DAC means which is indicative of the VCO frequency as modified by the integrating means generated frequency error signal is summed with the output from the PLL DAC means by adder means (40) to generate a bias voltage to adjust the VCO frequency to lie within the frequency range.

5. A method of controlling the frequency of a voltage controlled oscillator (VCO, 12) forming part of an interconnected phase lock loop (PLL) and frequency lock loop (FLL), including the step of setting, by means of the FLL, the free-running frequency of the VCO to a preselected value, comprising the steps of:
setting a digital-analog converter (DAC, 11) in the PLL, the output of the DAC being connected to the input of the VCO, such that its output represents substantially the centre of a preselected PLL lock range;
counting output pulses from the VCO;
counting pulses from a reference clock;
when the number of reference pulses reaches a preselected value, comparing the counted number of VCO output pulses with a preselected expected count corresponding to the preselected free-running frequency value; and
incrementing or decrementing the VCO free-running frequency according to whether the number of counted VCO pulses is lower or higher than the expected count;
the method comprising the further step of:
in response to a deviation of the VCO frequency outside a preselected frequency lock range, applying a signal indicative of the frequency error from means in the PLL for combination, in the FLL, with a signal indicative of the VCO free-running frequency to adjust the VCO free-running frequency to cause it to lie within said frequency lock range.

6. A method as claimed in claim 5 wherein the incrementing/decrementing step includes:
transmitting a signal indicative of the difference between the expected and counted pulse values to the VCO to voltage bias the VCO in one or more steps until the number of counted VCO pulses equals the expected count and the VCO is thereby set at its free-running frequency.

7. A method as claimed in claim 5 or claim 6 further including the step of maintaining the frequency of the VCO within a preselected frequency range, comprising the steps of:
enabling the PLL;
generating a phase error signal indicative of the phase and/or frequency difference between the VCO output signal and the incoming signal to the PLL;
generating a frequency error signal from the phase error signal; adding the phase error and frequency error signals to generate a signal reflecting the PLL frequency error; and
summing the PLL frequency error signal and signal indicative of the VCO frequency to produce a voltage to adjust the VCO frequency as necessary to maintain it within the preselected frequency range.

8. A method as claimed in claim 7 including the step of, in response to said deviation of the VCO frequency outside the frequency range, dynamically adjusting the VCO frequency by combining the frequency error signal generated from the phase error signal with a signal indicative of the VCO frequency and summing the combination signal and PLL phase error signal to produce a voltage to restore the VCO frequency to within said frequency range.

## Patentansprüche

1. Eine Schaltung zum Steuern der Frequenz eines spannungsgesteuerten Oszillators (VCO, 12), der Teil einer mit einer frequenzsynchronisierten Schleife (FLL) verbundenen phasensynchronisierten Schleife (PLL) ist, folgendes aufweisend:
einen Digital-Analog-Umrichter (DAC, 11) in der PLL, wobei der Ausgang des DAC mit dem Eingang des VCO verbunden ist;
Mittel zum Setzen des DAC, so daß dessen Ausgang im wesentlichen die Mitte eines vorgewählten PLL-Synchronisationsbereichs darstellt;
wobei die FLL zunächst die Freilauffrequenz des VCO auf einen vorgewählten Wert setzt, und die FLL folgendes aufweist:
einen ersten Zähler (31) zum Zählen der Ausgangsfrequenzimpulse vom VCO (12);
einen zweiten Zähler (30) zum Zählen der Frequenzimpulse von einem Bezugstaktgeber und Bereitstellen eines Strobe-Impulses beim Zählen bis zu einem vorgewählten Zählwert;
ein Register (35), in dem die dann vorhandene Zahl in dem ersten Zähler in Antwort auf den Strobe-Impuls gespeichert wird;
einen Komparator (34), der durch den Strobe-Impuls veranlaßt wird, die im Register gespeicherte Zahl mit einer vorgewählten erwarteten Zahl zu vergleichen, und einen Ausgang bereitstellt, wenn die gespeicherte von der erwarteten Zahl abweicht; und
Anpaßmittel (32, 37, 36, 10), die auf das Ausgangssignal vom Komparator reagieren und dem VCO ein Signal bereitstellen, um die Freilauffrequenz auf seinen vorgewählten Wert anzupassen;
die Schaltung umfaßt weiter Mittel (17, 39, 20) in der PLL, die auf eine Abweichung der VCO-Frequenz von einem vorgewählten Frequenzbereich reagieren, und an das genannte Anpaßmittel in der FLL ein Signal anlegen, wodurch die VCO-Freilauffrequenz so angepaßt wird, daß sie innerhalb des Frequenzbereichs liegt.

2. Eine Schaltung nach Anspruch 1, desweiteren Mittel aufweisend, mit denen die VCO-Frequenz in dem genannten vorgewählten Frequenzbereich gehalten wird, folgendes umfassend:
Mittel, die auf das VCO-Ausgangssignal und ein PLL-Eingangssignal reagieren und ein Signal erzeugen, das den PLL-Frequenzfehler anzeigt;
Steuermittel (40, 29) zum Summieren des PLL-Frequenzfehlersignals und eines Signals, das die VCO-Freilauffrequenz darstellt, und zum Einspeisen eines aus der resultierenden Summe abgeleiteten Steuersignals in den VCO, um die VCO-Frequenz so zu verändern, daß sie in dem Synchronisationsbereich gehalten wird.

3. Eine Schaltung nach Anspruch 2, bei der das PLL-Fehlergeneratormittel folgendes umfaßt:
Phasenfehlergenerator-Mittel (14) zum Erzeugen eines digitalen Phasenfehlersignals, das von dem VCO-Ausgangssignal und dem PLL-Eingangssignal abgeleitet wird;
Integratormittel (19) zum Ableiten eines digitalen Frequenzfehlersignals von dem digitalen Phasenfehlersignal;
PLL-Summierungsmittel (21) für das Summieren der Phasen- und Frequenzfehlersignale;
wobei der PLL-DAC (11) auf die resultierende Summe reagiert und ein analoges PLL-Frequenzfehlersignal bereitstellt, das dem Addiermittel (40) in dem genannten Steuermittel zugeführt und mit einem analogen VCO-Frequenzsignal summiert wird, das von dem DAC-Mittel (10) in der FLL geliefert wird, um eine Vormagnetisierungsspannung zur Anpassung der VCO-Frequenz zu erzeugen.

4. Eine Schaltung nach Anspruch 3, bei der das auf die genannte Frequenzabweichung reagierende Mittel folgendes umfaßt:
Mittel (17) zum Anzeigen der genannten Abweichung;
Mittel (39), die auf die genannte Anzeige ansprechen und das von dem Integratormittel erzeugte Frequenzfehlersignal dem DAC-Mittel in der FLL zuführen; und
Mittel (20), welches das Frequenzfehlersignal an das PLL-DAC-Mittel auf Null setzt, bei dem der Ausgang des FLL-DAC-Mittels, der die VCO-Frequenz anzeigt, wie sie durch das vom Integratormittel erzeugte Frequenzfehlersignal verändert wurde, mit dem Ausgang des PLL-DAC-Mittels durch Addiermittel (40) summiert wird, um eine Vormagnetisierungsspannung zu erzeugen, welche die VCO-Frequenz so anpaßt, daß sie innerhalb des Frequenzbereichs liegt.

5. Eine Methode zur Steuerung der Frequenz eines spannungsgesteuerten Oszillators (VCO, 12), der Teil einer mit einer frequenzsynchronisierten Schleife (FLL) verbundenen phasensynchronisierten Schleife (PLL) ist, die, mit Hilfe der FLL, den Schritt des Einstellens der Freilauffrequenz des VCO auf einen vorgewählten Wert umfaßt, der folgende Schritte aufweist:
Setzen eines Digital-Analog-Umrichters (DAC, 11) in der PLL, wobei der Ausgang des DAC mit dem Eingang des VCO verbunden wird, so daß sein Ausgang im wesentlichen die Mitte eines vorgewählten PLL-Synchronisationsbereichs darstellt;
Zählen der Ausgangsimpulse vom VCO;
Zählen der Impulse von einem Bezugstaktgeber;
wenn die Anzahl der Bezugsimpulse einen vorgewählten Wert erreicht, Vergleichen der gezählten Anzahl von VCO-Ausgangsimpulsen mit einer vorgewählten erwarteten Zahl, die dem vorgewählten Freilauffrequenz-Wert entspricht; und
Inkrementieren oder Dekrementieren der VCO-Freilauffrequenz, je nachdem, ob die Anzahl der gezählten VCO-Impulse niedriger oder höher als die erwartete Zahl ist;
wobei die Methode desweiteren den folgenden Schritt umfaßt:
in Antwort auf eine Abweichung der VCO-Frequenz von einem vorgewählten Frequenz-Synchronisationsbereich, Anlegen eines Signals, das den Frequenzfehler von Mitteln in der PLL anzeigt, um in der FLL mit einem Signal kombiniert zu werden, das die VCO-Freilauffrequenz anzeigt, um die VCO-Freilauffrequenz so anzupassen, daß sie in dem genannten Frequenz-Synchronisationsbereich liegt.

6. Ein Verfahren nach Anspruch 5, bei dem der Inkrementier-/Dekrementierschritt folgendes umfaßt:
Übertragen eines Signals, das den Unterschied zwischen den erwarteten und den gezählten Impulswerten zu dem VCO anzeigt, zur Spannungsvormagnetisierung des VCO in ein oder mehreren Schritten, bis die Anzahl der gezählten VCO-Impulse der erwarteten Zahl entspricht und die VCO dadurch auf ihre Freilauffrequenz gesetzt wird.

7. Ein Verfahren nach Anspruch 5 oder Anspruch 6, desweiteren den Schritt des Haltens der VCO-Frequenz in einem vorgewählten Frequenzbereich umfassend, folgende Schritte aufweisend:
Freigabe der PLL;
Erzeugen eines Phasenfehlersignals, das die Phasen- und/oder Frequenzdifferenz zwischen dem VCO-Ausgangssignal und dem ankommenden Signal an die PLL anzeigt;
Erzeugen eines Frequenzfehlersignals aus dem Phasenfehlersignal;
Addieren des Phasenfehler- und Frequenzfehlersignals zur Erzeugung eines Signals, das den PLL-Frequenzfehler wiedergibt; und
Summieren des PLL-Frequenzfehlersignals und des Signals, das die VCO-Frequenz anzeigt, um eine Spannung zu erzeugen, die die VCO-Frequenz so anpaßt, daß sie in dem vorgewählten Frequenzbereich gehalten wird.

8. Ein Verfahren nach Anspruch 7, in Antwort auf die genannte Abweichung der VCO-Frequenz von dem Frequenzbereich, den Schritt des dynamischen Anpassens der VCO-Frequenz umfassend, durch Kombinieren des aus dem Phasenfehlersignal erzeugten Frequenzfehlersignals mit einem Signal, das die VCO-Frequenz anzeigt, und Summieren des kombinierten Signals und des PLL-Phasenfehlersignals, zur Erzeugung einer Spannung, durch die die VCO-Frequenz wieder hergestellt wird, so daß sie in dem genannten Frequenzbereich liegt.

## Revendications

1. Circuit destiné à commander la fréquence d'un oscillateur commandé en tension (VCO, 12) faisant partie d'une boucle à verrouillage de phase (PLL) et d'une boucle à verrouillage de fréquence (FLL) reliées entre elles comprenant :
un convertisseur numérique/analogique (DAC, 11) situé dans la boucle à verrouillage de phase, la sortie du convertisseur numérique/analogique étant reliée à l'entrée de l'oscillateur commandé en tension,
un moyen servant à ajuster le convertisseur numérique/analogique d'une manière telle que sa sortie représente quasiment le centre d'une plage de verrouillage de la boucle à verrouillage de phase sélectionnée,
la boucle à verrouillage de fréquence pouvant être commandée pour ajuster initialement la fréquence d'oscillation libre de l'oscillateur commandé en tension à une valeur présélectionnée, la boucle à verrouillage de fréquence comprenant :
un premier compteur (31) servant à compter les impulsions de fréquence en sortie provenant de l'oscillateur commandé en tension (12),
un second compteur (30) servant à compter les impulsions de fréquence provenant d'une horloge de référence et à délivrer une impulsion d'échantillonnage lors du comptage jusqu'à une valeur de comptage présélectionnée,
un registre (35) dans lequel le compte ensuite existant dans le premier compteur est mémorisé en réponse à l'impulsion d'échantillonnage,
un comparateur (34) conditionné par l'impulsion d'échantillonnage pour comparer le compte mémorisé dans le registre à un compte présélectionné attendu pour délivrer une sortie lorsque les comptes mémorisés et attendus diffèrent, et
un moyen d'ajustement (32, 37, 36, 10) sensible au signal de sortie du comparateur pour délivrer un signal à l'oscillateur commandé en tension en vue d'ajuster la fréquence d'oscillation libre à sa valeur présélectionnée,
le circuit comprenant en outre un moyen (17, 39, 20) situé dans la boucle à verrouillage de phase sensible à une déviation de la fréquence de l'oscillateur commandé en tension à l'extérieur d'une plage de fréquence présélectionnée pour appliquer un signal audit moyen d'ajustement présent dans la boucle à verrouillage de fréquence en vue d'ajuster la fréquence d'oscillation libre de l'oscillateur commandé en tension pour l'amener à demeurer à l'intérieur de la plage de fréquence.

2. Circuit selon la revendication 1, comprenant en outre un moyen servant à maintenir la fréquence de l'oscillateur commandé en tension à l'intérieur de ladite plage de fréquence présélectionnée, comprenant :
un moyen sensible au signal de sortie de l'oscillateur commandé en tension et un signal d'entrée de la boucle à verrouillage de phase pour produire un signal indicatif de l'erreur de fréquence de la boucle à verrouillage de phase,
un moyen de commande (40, 29) servant à sommer le signal d'erreur de fréquence de la boucle à verrouillage de phase et un signal représentant la fréquence d'oscillation libre de l'oscillateur commandé en tension et à délivrer un signal de commande dérivé de la somme obtenue à l'oscillateur commandé en tension pour en modifier la fréquence comme il est nécessaire afin de maintenir celle-ci à l'intérieur de la plage de verrouillage.

3. Circuit selon la revendication 2, dans lequel le moyen de génération d'erreur de boucle à verrouillage de phase comprend :
un moyen de génération d'erreur de phase (14) servant à produire un signal d'erreur de phase numérique obtenu à partir du signal de sortie de l'oscillateur commandé en tension et du signal d'entrée de la boucle à verrouillage de phase,
un moyen d'intégration (19) servant à obtenir un signal d'erreur de fréquence numérique à partir du signal d'erreur de phase numérique,
un moyen de sommation de boucle à verrouillage de phase (21) servant à sommer les signaux d'erreur de phase et de fréquence,
le convertisseur analogique/numérique (11) de la boucle à verrouillage de phase étant sensible à la somme obtenue pour délivrer un signal d'erreur de fréquence de la boucle à verrouillage de phase analogique pour application au moyen d'additionneur (40) dans ledit moyen de commande pour sommation avec un signal de fréquence de l'oscillateur commandé en tension analogique délivré par le moyen de convertisseur numérique/analogique (10) présent dans la boucle à verrouillage de fréquence en vue de produire une tension de polarisation destinée à ajuster la fréquence de l'oscillateur commandé en tension.

4. Circuit selon la revendication 3, dans lequel le moyen sensible à ladite déviation de fréquence comprend :
un moyen (17) servant à indiquer ladite déviation,
un moyen (39) sensible à ladite indication pour délivrer le signal d'erreur de fréquence produit par le moyen d'intégration au moyen de convertisseur numérique/analogique présent dans la boucle à verrouillage de fréquence, et
un moyen (20) servant à positionner à zéro le signal d'erreur de fréquence destiné au moyen de convertisseur numérique/analogique de boucle à verrouillage de phase, dans lequel la sortie du moyen de convertisseur numérique/analogique de la boucle à verrouillage de fréquence est indicatif de la fréquence de l'oscillateur commandé en tension telle que modifiée par le signal d'erreur de fréquence généré par le moyen d'intégration est sommée avec la sortie provenant du moyen de convertisseur numérique/analogique de la boucle à verrouillage de phase par un moyen d'additionneur (40) pour générer une tension de polarisation destinée à ajuster la fréquence de l'oscillateur commandé en tension pour maintenir celle-ci à l'intérieur de la plage de fréquence.

5. Procédé de commande de la fréquence d'un oscillateur commandé en tension (VCO, 12) faisant partie d'une boucle à verrouillage de phase (PLL) et d'une boucle à verrouillage de fréquence (FLL) reliées entre elles, incluant les étapes consistant à ajuster, au moyen de la boucle à verrouillage de fréquence, la fréquence d'oscillation libre de l'oscillateur commandé en tension à une valeur présélectionnée, comprenant les étapes consistant à :
ajuster un convertisseur numérique/analogique (DAC, 11) présent dans la boucle à verrouillage de phase, la sortie du convertisseur numérique/analogique étant reliée à l'entrée de l'oscillateur commandé en tension d'une manière telle que sa sortie représente quasiment le centre d'une plage de verrouillage de la boucle à verrouillage de phase présélectionnée,
compter les impulsions de sortie provenant de l'oscillateur commandé en tension,
compter les impulsions provenant d'une horloge de référence,
lorsque le nombre d'impulsions de référence atteint une valeur présélectionnée, comparer le nombre compté d'impulsions de sortie de l'oscillateur commandé en tension à un compte présélectionné attendu correspondant à la valeur de fréquence d'oscillation libre présélectionnée, et
incrémenter ou décrémenter la fréquence d'oscillation libre de l'oscillateur commandé en tension selon que le nombre d'impulsions d'oscillateur commandé en tension compté est inférieur ou supérieur au compte attendu,
le procédé comprenant l'étape supplémentaire consistant à :
en réponse à une déviation de la fréquence de l'oscillateur commandé en tension à l'extérieur d'une plage de verrouillage de fréquence présélectionnée, appliquer un signal indicatif de l'erreur de fréquence provenant du moyen présent dans la boucle à verrouillage de phase pour combinaison, dans la boucle à verrouillage de fréquence, avec un signal indicatif de la fréquence d'oscillation libre de l'oscillateur commandé en tension en vue d'ajuster la fréquence d'oscillation libre de l'oscillateur commandé en tension pour amener celle-ci à demeurer à l'intérieur de ladite plage de verrouillage de fréquence.

6. Procédé selon la revendication 5, dans lequel l'étape d'incrémentation/décrémentation comprend les étapes consistant à :
transmettre un signal indicatif de la différence entre les valeurs d'impulsions attendues et comptées appliquées à l'oscillateur commandé en tension pour polariser la tension de l'oscillateur commandé en tension en une ou plusieurs étapes jusqu'à ce que le nombre d'impulsions de l'oscillateur commandé en tension compté soit égal au compte attendu, l'oscillateur commandé en tension étant ainsi ajusté à sa fréquence d'oscillation libre.

7. Procédé selon la revendication 5 ou 6, comprenant en outre l'étape consistant à maintenir la fréquence de l'oscillateur commandé en tension à l'intérieur d'une plage de fréquence présélectionnée, comprenant les étapes consistant à :
valider la boucle à verrouillage de phase,
produire un signal d'erreur de phase indicatif de la différence de phase et/ou de fréquence entre le signal de sortie de l'oscillateur commandé en tension et le signal entrant vers la boucle à verrouillage de phase,
produire un signal d'erreur de fréquence à partir du signal d'erreur de phase,
ajouter les signaux d'erreur de phase et d'erreur de fréquence pour produire un signal reflétant l'erreur de fréquence de la boucle à verrouillage de phase, et
sommer le signal d'erreur de fréquence de la boucle à verrouillage de phase et le signal indicatif de la fréquence de l'oscillateur commandé en tension en vue de produire une tension permettant d'ajuster la fréquence de l'oscillateur commandé en tension comme il est nécessaire pour maintenir celle-ci à l'intérieur de la plage de fréquence présélectionnée.

8. Procédé selon la revendication 7, comprenant l'étape consistant à, en réponse à ladite déviation de la fréquence de l'oscillateur commandé en tension à l'extérieur de la plage de fréquence, ajuster dynamiquement la fréquence de l'oscillateur commandé en tension en combinant le signal d'erreur de fréquence produit à partir du signal d'erreur de phase à un signal indicatif de la fréquence de l'oscillateur commandé en tension et à sommer le signal de combinaison et le signal d'erreur de phase de la boucle à verrouillage de phase en vue de produire une tension destinée à ramener la fréquence de l'oscillateur commandé en tension à l'intérieur de ladite plage de fréquence.
